# EUROPEAN PATENT APPLICATION

(11) **EP 3 528 177 A1**
(43) Date of publication of application: **21.08.2019**
(21) Application number: 19157191.8
(22) Date of filing: 14.02.2019
(51) Int. Cl.: G06K 19/077, G06K 19/07

(54) **IC CARD**

(30) Priority: 16.02.2018 JP 2018025754
(71) Applicant: Kabushiki Kaisha Toshiba, Minato-ku Tokyo 105-0023 (JP); Toshiba Infrastructure Systems & Solutions Corporation, Kawasaki-shi, Kanagawa 212-0013 (JP)
(72) Inventor: ARAI, Hideaki, Kawasaki-shi, Kanagawa 212-0013 (JP)
(74) Representative: Horn Kleimann Waitzhofer Patentanwälte PartG mbB

(57) **Abstract**

According to one embodiment, an IC card includes a card base member, a film-shaped substrate, a structure, and a stress concentration portion. The substrate is arranged within the card base member and includes wiring. The structure is mounted on the substrate, is connected to the wiring, and is provided within the card base member. The stress concentration portion is provided within the card base member and in or outside the periphery of the structure in a principal surface direction of the card base member, the stress concentration portion on which stress that is generated when an external force is applied is concentrated.

## Description

### FIELD

Embodiments described herein relate generally to an IC card.

### BACKGROUND

Recently, high-performance IC cards incorporate on-board components mounted on a film-shaped substrate, such as an IC chip, an MPU, a capacitor, a fingerprint sensor, etc. On-board components are mounted inside IC cards are known. Thus, when stress such as bending stress is generated in an IC card, there is a risk that such stress is concentrated on an end portion of an on-board component. Concentration of stress on an end portion of an on-board component brings about a risk of damaging a substrate or the on-board component.

### BRIEF DESCRIPTION OF THE DRAWINGS

FIG. 1 is a plan view showing a configuration of an IC card according to a first embodiment.
FIG. 2 is a cross-sectional view taken along line II-II in FIG. 1, for showing a cross-sectional shape of the IC card.
FIG. 3 is a plan view showing a configuration of an IC card according to a second embodiment.
FIG. 4 is a cross-sectional view taken along line IV-IV in FIG. 3, for showing a cross-sectional shape of the IC card.
FIG. 5 is a plan view showing a configuration of an IC card according to a third embodiment.
FIG. 6 is a cross-sectional view taken along line VI-VI in FIG. 5, for showing a cross-sectional shape of the IC card.

### DETAILED DESCRIPTION

According to one embodiment, an IC card includes a card base member, a film-shaped substrate, a structure, and a stress concentration portion. The substrate is arranged within the card base member and includes wiring. The structure is mounted on the substrate, is connected to the wiring, and is provided within the card base member. The stress concentration portion is provided within the card base member and in or outside the periphery of the structure in a principal surface direction of the card base member, the stress concentration portion on which stress that is generated when an external force is applied is concentrated.

### (First Embodiment)

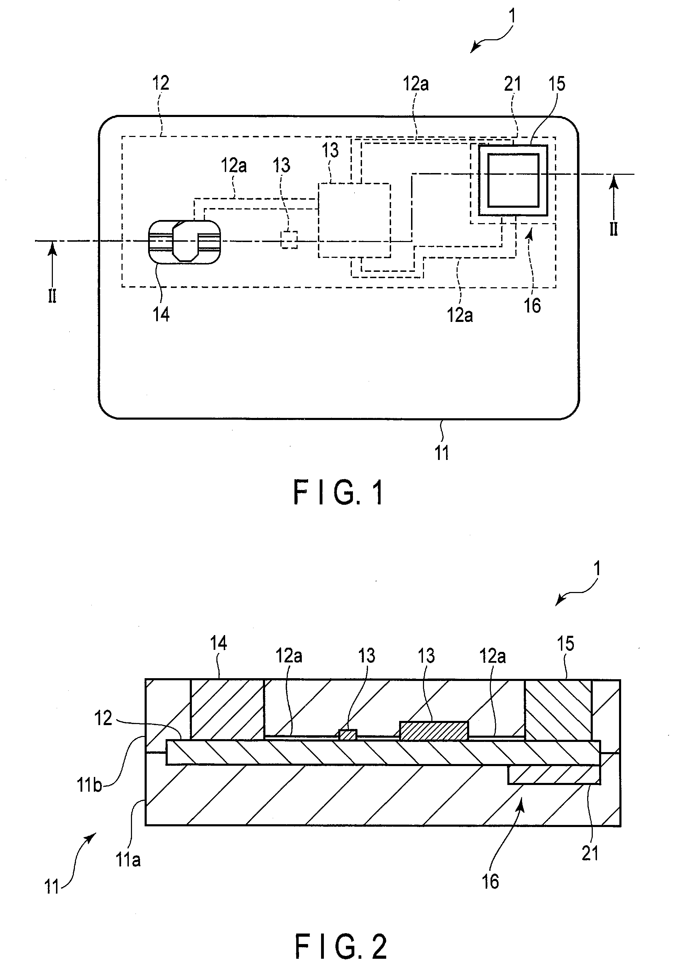

Hereinafter, an IC card 1 according to a first embodiment will be described with reference to FIG. 1 and FIG. 2. FIG. 1 is a plan view showing a configuration of the IC card 1 according to the first embodiment. FIG. 2 is a cross-sectional view taken along line II-II in FIG. 1, for showing a cross-sectional shape of the IC card 1. For convenience of description, each structure shown in FIG. 1 and FIG. 2 is simplified in shape, or enlarged or reduced in size. A principal surface direction of the IC card 1 (card base member 11) denotes a direction in parallel to a principal surface in a direction perpendicular to a thickness direction of the IC card 1 (card base member 11).

The IC card 1 includes the card base member 11, a substrate 12 provided inside the card base member 11, electronic components 13 mounted on the substrate 12, a contact terminal 14 mounted on the substrate 12, and a finger print sensor 15 mounted on the substrate 12. The IC card 1 further includes a stress concentration portion 16. Because of bending of the card base member 11, for example, when an external force is applied to the IC card 1, thereby generating bending stress therein, such bending stress is concentrated on the stress concentration portion 16.

The card base member 11 includes a first sheet 11a and a second sheet 11b. For example, the first sheet 11a is made of a resin material, and is formed in a rectangular shape that is longer in one direction. The second sheet 11b is made of a resin material, and is provided with openings through which the contact terminal 14 and the finger print sensor 15 are exposed. The card base member 11 is formed in a manner such that its external shape is substantially the same as the external shape of the IC card 1. For example, the card base member 11 is formed by bonding the first sheet 11a and the second sheet 11b integrally. The card base member 11 may be formed by means of resin molding.

The substrate 12 is a film-shaped substrate. For example, the substrate 12 is formed in a rectangular shape. The substrate 12 includes printed wiring 12a that electrically connects the electronic components 13, the contact terminal 14, and the finger print sensor 15, which are mounted on the substrate 12. On the substrate 12, the electronic components 13, the contact terminal 14, and the finger print sensor 15, are mounted as on-board components inside the periphery.

Examples of the electronic components 13 include an IC, an MPU (Micro Processing Unit), an MCU (Micro Controller Unit), etc., which is to process images scanned by the finger print sensor 15.

The contact terminal 14 is a module terminal that comes in contact with a reader/writer terminal of a card terminal device. The contact terminal 14 is mounted on the substrate 12 in a mode in which, for example, the contact terminal 14 includes a secure IC chip. A specific example of this mode is that the contact terminal 14 is coupled to a secure IC chip by means of wire bonding or flip-chip mounting. The secure IC chip is not always stacked in the same position on the substrate 12 as the contact terminal 14. The secure IC chip may be mounted in a different position on the substrate 12 and be electrically connected to the contact terminal 14 in a manner such that the secure IC chip and the contact terminal 14 have a predetermined wiring relation.

The finger print sensor 15 is a structure that is mounted on the substrate 12 and is shaped larger in the principal surface direction of the card base member 11 than the electronic components 13 and the contact terminal 14 that are mounted on the substrate 12. The finger print sensor 15 is formed in, for example, a rectangular sheet shape. The finger print sensor 15 has a different bending strength from that of the card base member 11. That is, by providing the card base member 11 with the finger print sensor 15, bending strength of the IC card 1 is partially varied in the principle surface direction of the card base member 11. For example, the finger print sensor 15 is arranged in a position that is closer to one end in the longitudinal direction of the card base member 11 and is closer to one end in the lateral direction of the card base member 11.

The substrate 12 is provided with a stress concentration portion 16 on a surface opposite to a surface on which the finger print sensor 15 is mounted, in a manner such that the stress concentration portion 16 faces the finger print sensor 15. The stress concentration portion 16 includes a reinforcing plate 21 in a thin plate form that is shaped larger than the finger print sensor 15 in the principal surface direction of the card base member 11. The reinforcing plate 21 is configured so as to be higher in bending strength than the card base member 11 and the finger print sensor 15. For example, the reinforcing plate 21 is made of a metallic material such as stainless steel. The reinforcing plate 21 is provided within the card base member 11. The reinforcing plate 21 is positioned in a manner such that the periphery of the reinforcing plate 21 is placed outside the periphery of the finger print sensor 15 in the principal surface direction of the card base member 11, and that the reinforcing plate 21 and the finger print sensor 15 face each other with the substrate 12 being sandwiched therebetween in a thickness direction of the card base member 11.

The stress concentration portion 16 is configured in a manner such that the reinforcing plate 21 that is larger than the finger print sensor 15 in the principal surface direction of the card member 11 is provided in a position in which the reinforcing plate 21 and the finger print sensor 15 face each other with the substrate 12 being sandwiched therebetween. With this configuration, when bending stress is generated in the card base member 11, bending stress is concentrated on a boundary between the periphery of the reinforcing plate 21 and the card base member 11.

The IC card 1 thus configured is provided with the reinforcing plate 21 shaped larger than the finger print sensor 15 in the principal surface direction of the card base member 11, in a manner such that the reinforcing plate 21 faces the finger print sensor 15. In the IC card 1 with this configuration, the stress concentration portion 16 on which bending stress is concentrated when it is applied to the card base member 11 is formed of a region of the reinforcing plate 21 and a region of the card base member 11, in which both of the regions are arranged outside the periphery of the finger print sensor 15 in the principal surface direction of the card base member 11. Accordingly, the above configuration prevents concentration of bending stress on the periphery of the finger print sensor 15, thereby suppressing damage of the finger print sensor 15 and both the card base member 11 and the substrate 12 on the periphery of the finger print sensor 15. As a result, the IC card 1 can be prevented from being damaged.

As described above, with the IC card 1 according to the first embodiment, it is possible to alleviate local concentration of stress on the periphery of the finger print sensor 15 as an on-board component when bending stress is generated in the IC card 1. Therefore, the IC card 1 can be prevented from being damaged by stress that is generated when an external force is applied.

### (Second Embodiment)

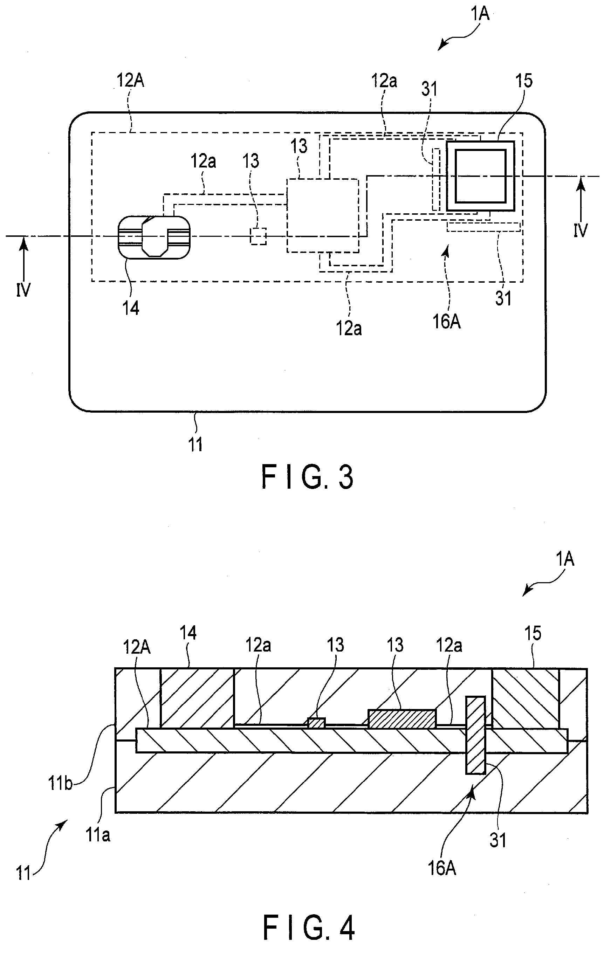

Next, an IC card 1A according to a second embodiment will be described with reference to FIG. 3 and FIG. 4.

FIG. 3 is a plan view showing a configuration of the IC card 1A according to the second embodiment. FIG. 4 is a cross-sectional view taken along line IV-IV in FIG. 3, for showing a cross-sectional shape of the IC card 1A. For convenience of description, each structure shown in FIG. 3 and FIG. 4 is simplified in shape, or enlarged or reduced in size. In the configurations of the IC card 1A according to the second embodiment, the same configurations as those in the IC card 1 according to the first embodiment are assigned with the same reference numerals, and a detailed description of such configurations is omitted.

The IC card 1A includes the card base member 11, a substrate 12A, the electronic components 13, the contact terminal 14, and the finger print sensor 15. In the IC card 1A, the card base member 11 includes a stress concentration portion 16A. When bending stress is applied to the card base member 11 due to, e.g., bending of the card base member 11, such bending stress is concentrated on the stress concentration portion 16A.

The stress concentration portion 16A is provided next to the periphery of the finger print sensor 15 in the principal surface direction of the card base member 11, and includes members 31 having a lower bending strength than that of the card base member 11. For example, two members 31 are provided inside the card base member 11 in a manner to be adjacent to each other along two adjacent sides of the periphery of the finger print sensor 15, the two adjacent sides being located closer to the center of the card base member 11. The two members 31 are shaped in a manner to extend along these two sides of the periphery of the finger print sensor 15. That is, the stress concentration portion 16A is configured in a manner such that regions of the IC card 1A, in which the members 31 are provided in the principal surface direction of the card base member 11, are made lower in bending strength than the other regions. With this configuration, when bending stress is generated in the IC card 1A, such bending stress is concentrated on the stress concentration portion 16A.

As shown in FIG. 3, the printed wiring 12a of the substrate 12A is arranged in a manner to avoid the regions provided with the members 31.

In the IC card 1A thus configured, the members 31 having a lower bending strength than that of the card base member 11 are provided within the card base member 11, in a position adjacent to the finger print sensor 15. Therefore, the regions provided with the members 31 adjacent to the finger print sensor 15 within the card base member 11 have the lowest bending strength in the IC card 1A. Therefore, when bending stress is generated in the IC card 1A, the regions provided with the members 31 outside the periphery of the finger print sensor 15 constitute the stress concentration portion 16A on which bending stress is concentrated. Accordingly, the above configuration prevents concentration of bending stress on the periphery of the finger print sensor 15, thereby suppressing damage of the finger print sensor 15 and both the card base member 11 and the substrate 12A on the periphery of the finger print sensor 15. As a result, the IC card 1A can be prevented from being damaged.

The configuration that the printed wiring 12a is provided to the substrate 12A in a manner to avoid the members 31 prevents concentration of bending stress on the printed wiring 12a even when bending stress is concentrated on the regions provided with the members 31 in the card base member 11. Accordingly, breakage of the printed wiring 12a can also be prevented.

As described above, with the IC card 1A according to the second embodiment, it is possible to alleviate local concentration of stress on the periphery of the finger print sensor 15 as an on-board component when bending stress is applied to the card base member 11, as in the IC card 1 described above. Therefore, the IC card 1A can be prevented from being damaged by stress that is generated when an external force is applied.

### (Third Embodiment)

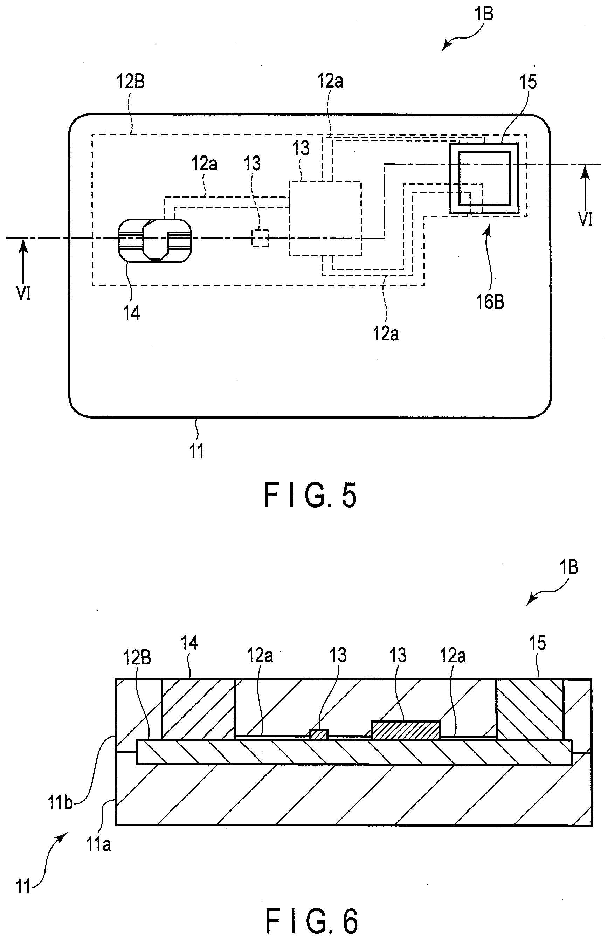

Next, an IC card 1B according to a third embodiment will be described with reference to FIG. 5 and FIG. 6.

FIG. 5 is a plan view showing a configuration of the IC card 1B according to the third embodiment. FIG. 6 is a cross-sectional view taken along line VI-VI in FIG. 5, for showing a cross-sectional shape of the IC card 1B. For convenience of description, each structure shown in FIG. 5 and FIG. 6 is simplified in shape, or enlarged or reduced in size. In the configurations of the IC card 1B according to the third embodiment, the same configurations as those in the IC card 1 according to the first embodiment are assigned with the same reference numerals, and a detailed description of such configurations is omitted.

The IC card 1B includes the card base member 11, a substrate 12B formed within the card base member 11, electronic components 13 mounted on the substrate 12B, the contact terminal 14 mounted on the substrate 12B, and the finger print sensor 15 mounted on the substrate 12B. In the IC card 1B, the card base member 11 includes a stress concentration portion 16B. When bending stress is applied to the card base member 11 due to, e.g., bending of the card base member 11, such bending stress is concentrated on the stress concentration portion 16B.

The substrate 12B is a film-shaped substrate. The substrate 12B includes the printed wiring 12a that electrically connects the electronic components 13, the contact terminal 14, and the finger print sensor 15, which are mounted on the substrate 12B. On the substrate 12B, the electronic components 13 and the contact terminal 14 are mounted as on-board components inside the periphery.

As shown in FIG. 5, the substrate 12B is shaped in a manner such that a part of the periphery of a region in which the finger print sensor 15 is mounted extends along one side (hereinafter referred to as a "first side") of the periphery of the mounted finger print sensor 15 and is located in the same position as the first side of the periphery of the finger print sensor 15 in a direction perpendicular to a thickness direction of the card base member 11 when viewed from the thickness direction. More specifically, the substrate 12B is shaped in a manner such that a part of the periphery of the region in which the finger print sensor 15 is mounted extends along the first side of the finger print sensor 15, the first side being located closer to the center in the lateral direction of the card base member 11, and is located in the same position as the first side of the periphery of the finger print sensor 15 in the direction perpendicular to the thickness direction of the card base member 11 when viewed from the thickness direction. In other words, a part of the periphery of the region within the substrate 12B, in which the finger print sensor 15 is mounted, is formed along the first side of the periphery of the finger print sensor 15 in a manner to be located in the same position as the first side of the periphery of the finger print sensor 15 in the direction perpendicular to the thickness direction of the card base member 11 when viewed from the thickness direction.

Since a part of the periphery of the region within the substrate 12B, in which the finger print sensor 15 is mounted, is formed along the first side of the periphery of the finger print sensor 15, this first side of the periphery of the finger print sensor 15 becomes the stress concentration portion 16B. The substrate 12B is not located outside the first side of the periphery of the finger print sensor 15, in the principal surface direction of the card base member 11. As a result, the printed wiring 12a is not arranged outside the first side of the periphery of the finger print sensor 15, in the principal surface direction of the card base member 11. This enables the IC card 1B to prevent the printed wiring 12a from being broken even when bending stress is concentrated on the first side of the periphery of the finger print sensor 15, which is located in the same position as the substrate 12B in the direction perpendicular to the thickness direction of the card base member 11 when viewed from the thickness direction.

The IC card 1B thus configured has the substrate 12B shaped in a manner to have a part extending along the first side of the periphery of the finger print sensor 15. This shaping prevents concentration of bending stress in a region provided with the printed wiring 12a within the substrate 12B even when the stress concentration portion 16B is set to the first side of the periphery of the finger print sensor 15. This enables the IC card 1B to prevent breakage of the printed wiring 12a. Accordingly, even when bending stress is concentrated on the first side of the periphery of the finger print sensor 15, damage of the substrate 12B can be suppressed. As a result, the IC card 1 B can be prevented from being damaged.

As described above, with the IC card 1B according to the third embodiment, it is possible to alleviate local concentration of stress on a region provided with the printed wiring 12a within the substrate 12B when bending stress is applied to the card base member 11. Therefore, the IC card 1B can be prevented from being damaged by stress that is generated when an external force is applied.

With the IC card according to at least one of the embodiments described above, it is possible to alleviate local concentration of stress on the substrate or the on-board component due to stress that is generated when an external force is applied. Thus, the IC card can be prevented from being damaged.

In the embodiments described above, the finger print sensor 15 is described as an on-board component that is a structure on which local concentration of stress is alleviated. However, such a structure is not limited to the finger print sensor 15, and a configuration in which the stress concentration portion 16 is additionally provided to the electronic components 13 or the contact terminal 14 is applicable. For the IC cards 1, 1A, and 1B described above, the configuration provided with the finger print sensor 15 is described as a structure on which local concentration of stress is alleviated. However, such a structure is not limited to the finger print sensor 15, and may be a touch panel, a display, a button, etc. That is, as long as a structure is an on-board component that is made of a member to be mounted on the IC card 1 and is mounted on the card member 11 so as to partially vary a bending strength of the card base member 11, and there is a risk that stress generated by an external force is concentrated on this on-board component, such a structure can be set as appropriate.

In the embodiments described above, bending stress that is generated when an external force is applied in a manner to bend the card base member 11 is described as stress generated in the card base member 11. However, this is not a limitation. That is, examples of stress generated in the card base member 11 include stress generated by an external force that is applied to the card base member 11 at the time of normal use or storage of the IC card. Examples further include, in the case of the IC card provided with the finger print sensor 15, a touch panel, a button, or the like, as a structure, stress generated by an external force that is generated at the time of operation or usage of such a structure.

The embodiments described above are applicable in combination. For example, the IC card may be configured in a manner such that the member 31 is provided in a region adjacent to the finger print sensor 15 within the card base member 11, and that a part of the periphery of the substrate 12B, in which the finger print sensor 15 is mounted, extends to one side of the periphery of the finger print sensor 15. In addition, for example, the IC card may be configured in a manner such that the reinforcing plate 21 is provided, and that the member 31 is provided in a region adjacent to the finger print sensor 15 and the reinforcing plate 21 within the card base member 11.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. An IC card (1;1A;1B) comprising:
a card base member (11);
a film-shaped substrate (12;12A;12B) that is arranged within the card base member (11) and includes wiring (12a);
a structure (15) that is mounted on the substrate (12;12A;12B), is connected to the wiring (12a), and is provided within the card base member (11); and
a stress concentration portion (16;16A;16B) that is provided within the card base member (11) and in or outside the periphery of the structure (15) in a principal surface direction of the card base member (11), the stress concentration portion (16;16A;16B) being a portion on which stress that is generated when an external force is applied is concentrated.

2. The IC card (1;1A;1B) according to claim 1, wherein the structure (15) is a finger print sensor (15) and includes a surface exposed from the card base member (11).

3. The IC card (1) according to claim 1 or 2, further comprising a reinforcing plate that is formed to be larger than the structure (15) in the principal surface direction of the card base member (11), is provided to a surface of the substrate (12), the surface being opposed to a mounting surface on which the structure (15) is mounted, and has a higher bending strength than the card base member (11),
wherein the stress concentration portion (16) is formed of a boundary between a periphery of the reinforcing plate and the card base member (11).

4. The IC card (1A) according to claim 1 or 2, wherein the stress concentration portion (16A) is formed of a member that is arranged outside the periphery of the structure (15) in the principal surface direction of the card base member (11) in a manner to extend the periphery of the structure (15) within the card base member (11), the member being lower in bending strength than the card base member (11).

5. The IC card (1B) according to claim 1 or 2, wherein:
the structure (15) is formed to be different in bending strength from the card base member (11);
the substrate (12B) is configured in a manner such that a part of a periphery of a region in which the structure (15) is mounted corresponds to a part of the periphery of the structure (15) in the principal surface direction of the card base member (11); and
the stress concentration portion (16B) is formed of a boundary between the card base member (11) and the part of the periphery of the region within the substrate (12B), in which the on-board component is mounted.
